# FASCICULE DE BREVET EUROPEEN

(11) **EP 2 452 361 B1**
(45) Date de publication et mention de la délivrance du brevet: **08.05.2013**
(21) Numéro de dépôt: 10728234.5
(22) Date de dépôt: 05.07.2010
(51) Int. Cl.: H01L 27/146, H01L 31/0376

(54) **DISPOSITIF PHOTO-DÉTECTEUR ET PROCÉDÉ DE RÉALISATION DE DISPOSITIF PHOTO-DÉTECTEUR**
PHOTODETEKTOR UND VERFAHREN ZUR HERSTELLUNG EINES PHOTODETEKTORS
PHOTO-DETECTOR DEVICE AND METHOD OF PRODUCING A PHOTO-DETECTOR DEVICE

(30) Priorité: 07.07.2009 FR 0954686
(43) Date de publication de la demande: 16.05.2012
(73) Titulaire: Commissariat à l'Énergie Atomique et aux Énergies Alternatives, 75015 Paris (FR)
(72) Inventeur: GIDON, Pierre, F-38130 Echirolles (FR); GIFFARD, Benoit, F-38000 Grenoble (FR); MOUSSY, Norbert, F-38190 Sainte Agnès (FR)
(74) Mandataire: Ilgart, Jean-Christophe
(86) Numéro de dépôt international: PCT/EP2010/059518
(87) Numéro de publication internationale: WO 2011/003843

(56) Documents cités:
- US-A- 4 581 625
- US-A- 4 785 186
- US-A1- 2005 263 839
- US-A1- 2005 264 662
- US-A1- 2008 055 443

## Description

### DOMAINE TECHNIQUE

L'invention concerne le domaine des dispositifs photo-détecteur, ou capteurs d'images, microélectroniques, et plus particulièrement celui des dispositifs photo-détecteurs couleurs du type « above IC », c'est-à-dire comportant une partie photo-détectrice disposée au-dessus d'un circuit intégré réalisant un traitement des charges électriques générées par la partie photo-détectrice.

L'invention concerne également un procédé de réalisation d'un tel dispositif photo-détecteur, notamment du type « above IC ».

### ÉTAT DE LA TECHNIQUE ANTÉRIEURE

Il existe plusieurs types de capteurs d'images microélectroniques :
- les capteurs dits CCD (Coupled Charges Device) générant, à partir de photons lumineux reçus par le capteur, des paires électron-trou par effet photoélectrique dans un substrat semi-conducteur cristallin, puis collectant les électrons dans des puits de potentiels,
- les capteurs dits CMOS (Complementary Metal Oxide Semi-conducteur) ou APS (Active Pixel Sensor) dans lesquels chaque zone de collecte de charges générées dans un semi-conducteur cristallin est accompagnée d'un amplificateur,
- les capteurs dits « above IC », faisant partie de la famille des capteurs CMOS, où les charges sont générées dans un ou plusieurs matériaux photo-détecteurs placés au-dessus d'un circuit intégré servant principalement d'amplificateur.

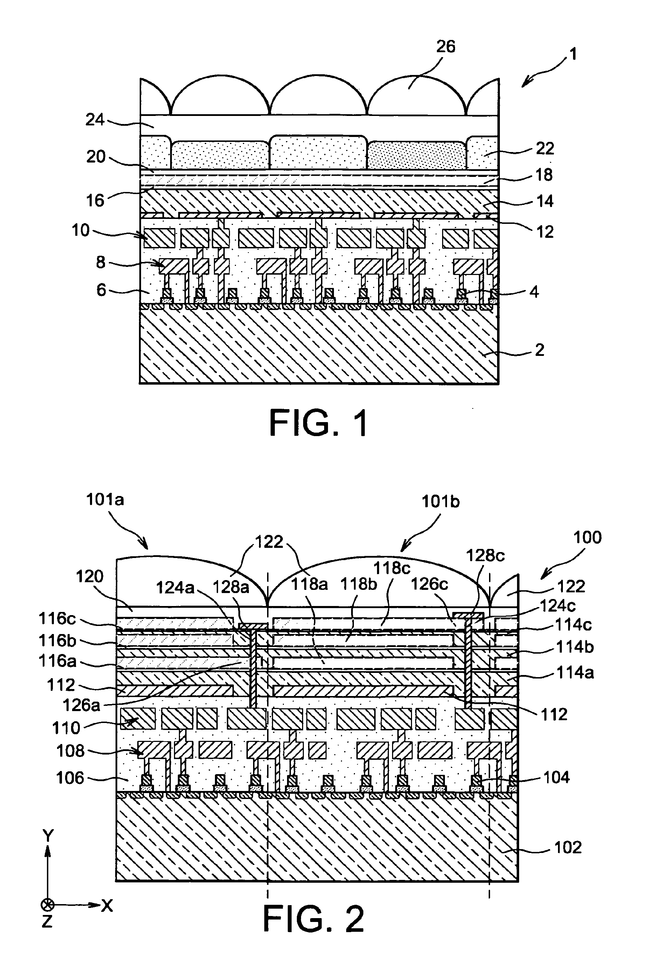

Afin de déterminer les coordonnées colorimétriques, telles que celles conformes aux normes CIE XYZ, RGB ou Lab, d'une lumière reçue, les capteurs d'images microélectroniques sont généralement équipés de filtres colorés, généralement au nombre de 3 ou 4, placés côte à côte sur différents photo-détecteurs du capteur. Le document << A highly reliable Amorphous Silicon photosensor for above IC CMOS image sensor" de N. Moussy et al., International Electron Devices Meeting 2006, IEDM'06, 11-13 décembre 2006, pages 1-3, décrit un tel capteur d'images, qui est également représenté sur la figure 1 et comportant la référence 1.

Ce capteur d'images 1 se compose de deux parties : le circuit intégré et la rétine disposée au-dessus du circuit intégré (above IC). Le circuit intégré comporte un substrat 2 sur lequel sont réalisés des transistors CMOS 4. Une couche diélectrique 6 recouvre les transistors CMOS 4. Plusieurs couches d'interconnexions électriques, reliées électriquement entre elles ainsi qu'aux transistors CMOS 4, sont réalisées dans la couche diélectrique 6. Sur l'exemple de la figure 1, le capteur 1 comporte une première couche d'interconnexions 8 et une seconde couche d'interconnexions 10. La rétine, formée par les éléments disposés au-dessus de la couche diélectrique 6, comporte plusieurs électrodes inférieures 12, par exemple à base de chrome. Chaque pixel du capteur 1 comporte une des électrodes inférieures 12. Ces électrodes inférieures 12 sont reliées électriquement à la seconde couche d'interconnexions 10 et recouvertes par une couche épaisse de silicium amorphe intrinsèque 14 elle-même recouverte d'une couche mince de silicium amorphe dopé 16. Une électrode supérieure transparente 18, à base d'ITO (oxyde d'indium et d'étain) et commune à tous les pixels du capteur 1, est disposée sur la couche mince de silicium amorphe dopé 16. Une couche de passivation 20 sépare des filtres colorés 22 (un filtre par pixel, et disposés par exemple selon un filtre de Bayer) de l'électrode supérieure 18. Les filtres colorés 22 sont recouverts d'une couche de planarisation 24 sur laquelle des micro-lentilles 26 (une par pixel) sont disposées.

Etant donné que les couches de silicium amorphe 14 et 16 ont des dopages différents (l'une étant intrinsèque et l'autre dopée), elles forment une jonction métallurgique, et donc une photodiode. La lumière absorbée dans ces couches 14, 16 de silicium amorphe génère des charges électriques qui sont alors séparées par le champ électrique présent dans la photodiode. Les charges collectées constituent le signal électrique qui est ensuite amplifié par le circuit intégré du capteur 1.

Dans un tel capteur d'images, les filtres colorés absorbent plus des deux tiers de la lumière reçue par le capteur. Un seul tiers de la lumière reçue est donc utilisable pour réaliser la photo-détection proprement dite.

Il est également connu de réaliser des capteurs d'images couleurs ne comportant pas de filtres colorés. Par exemple, le document US 2005/0205958 A1 décrit un capteur d'images ne comportant pas de filtres colorés, mais dans lequel sont empilées différentes couches photo-détectrices.

Ce capteur comporte en outre un grand nombre d'électrodes sous forme de couches électriquement conductrices, séparées les unes des autres par des couches diélectriques et intercalées entre les couches photo-détectrices. Dans un tel empilement, la réalisation des connexions électriques entre les électrodes et les amplificateurs du circuit intégré est complexe et contraignante. De plus, l'isolation électrique de ces connexions est un problème car elles ajoutent de nombreuses étapes au procédé de réalisation du dispositif par rapport à un procédé de réalisation d'un capteur comportant des filtres colorés, ce qui augmente sensiblement le coût de production d'un tel capteur par rapport à un capteur à filtres colorés.

Les documents US-A-4581625, US-A-4785186 décrivent des photodiodes de type p-i-n empolées, les documents US-A1-2005264662, US-A1-2008055443, US-A1-2005263839 décrivent des capteurs d'image de type <<above IC>>.

### EXPOSÉ DE L'INVENTION

Un but de la présente invention est de proposer un dispositif photo-détecteur, ou capteur d'images, par exemple de type « above IC », dont la structure facilite notamment la réalisation de connexions électriques avec la partie du dispositif réalisant la photo-détection, et qui soit peu coûteux à réaliser.

Pour cela, il est proposé un dispositif photo-détecteur selon la revendication 1.

Un semi-conducteur amorphe intrinsèque correspond à un semi-conducteur amorphe non dopé, c'est-à-dire n'ayant pas subi un ajout volontaire de dopants.

Ce dispositif photo-détecteur comporte donc une structure photo-détectrice comportant plusieurs couches de semi-conducteur amorphe, par exemple du silicium amorphe, éventuellement continues, comprises entre des électrodes pouvant être à base d'un matériau électriquement conducteur et transparent aux longueurs d'ondes à détecter, par exemple à base d'ITO. Dans cet empilement, on a donc une alternance électrode - photodiode - électrode - photodiode - ... Ainsi, deux photodiodes de l'empilement adjacente l'une au-dessus de l'autre sont séparées l'une de l'autre par une des électrodes à base du matériau électriquement conducteur.

Ainsi, il est proposé un dispositif photo-détecteur, par exemple du type « above IC », ne comportant pas de filtres colorés et permettant d'obtenir, par exemple, les coordonnées colorimétriques, par exemple celles conformes aux normes CIE XYZ, RGB ou Lab, de la lumière reçue par le dispositif photo-détecteur, ou l'image thermique d'une scène.

La taille des électrodes transparentes peut notamment délimiter les pixels dans la partie photo-détectrice du dispositif, c'est-à-dire présenter des dimensions légèrement inférieures à la taille des pixels.

Etant donné que le semi-conducteur amorphe est un mauvais conducteur électrique quand il est intrinsèque et non éclairé, il isole électriquement les électrodes dans les zones ombragées ou non éclairées, c'est-à-dire autour des électrodes. Ainsi, ce dispositif photo-détecteur ne nécessite pas de couches diélectriques pour isoler électriquement les électrodes car ce rôle d'isolation est rempli par les portions de semi-conducteur amorphe non-éclairées autour des électrodes.

Un tel dispositif photo-détecteur ne nécessite pas non plus de couches ou de portions diélectriques supplémentaires pour isoler électriquement des connexions électriques qui pourront être réalisées à travers les couches de semi-conducteur amorphe pour réaliser un contact électrique avec les électrodes sans étapes d'isolation spécifiques pour ces connexions. De plus, cette absence de couches diélectriques dans la structure photo-détectrice permet d'augmenter la surface effective dédiée à la collecte de la lumière par rapport aux surfaces dédiées à la collecte de la lumière dans les dispositifs de l'art antérieur.

Par rapport à un dispositif photo-détecteur comportant des filtres colorés, ce dispositif photo-détecteur peut disposer de pixels de tailles plus importantes, c'est-à-dire dont les dimensions qui sont sensiblement perpendiculaires aux rayons lumineux reçus par le capteur sont supérieures à ces mêmes dimensions des pixels des dispositifs photo-détecteurs à filtres colorés, car dans ce dispositif, chaque pixel délivre plusieurs signaux (un signal par photodiode), par exemple au moins deux, permettant de retrouver les coordonnées colorimétriques de la lumière reçue, alors que quatre pixels sont nécessaires dans un dispositif photo-détecteur comportant des filtres colorés disposés selon un filtre de Bayer pour obtenir la même information.

Le matériau détecteur peut être choisi tel qu'il ne soit sensible qu'au spectre lumineux destiné à être détecté par le dispositif photo-détecteur. Dans le cas où le dispositif photo-détecteur est destiné à réaliser une détection de couleurs dans la gamme des longueurs d'ondes de la lumière visible (comprise entre environ 380 nm et 780 nm), le semi-conducteur amorphe peut être du silicium car ce semi-conducteur est transparent aux infrarouges, et les optiques, par exemple des micro-lentilles, qui peuvent être couplées au dispositif photo-détecteur sont en général opaques aux ultra-violets. Ainsi, seul le spectre visible sera détecté par le dispositif photo-détecteur sans l'ajout de moyens de filtrage supplémentaires que l'on trouve classiquement associés aux filtres de Bayer de l'art antérieur.

Il est proposé un dispositif photo-détecteur comportant une pluralité de pixels, chaque pixel comprenant au moins un empilement alterné de plusieurs photodiodes et de plusieurs électrodes à base d'un matériau électriquement conducteur, et dans lequel :
- chaque photodiode comporte au moins une couche de semi-conducteur amorphe intrinsèque disposée en contact avec au moins une couche de semi-conducteur amorphe dopé distinctes des couches de semi-conducteur amorphe des autres photodiodes, chaque photodiode étant disposée entre au moins deux desdites électrodes, et chaque paire de photodiodes comportant au moins une des électrodes disposée entre ces photodiodes,
- dans chaque pixel, chaque électrode comporte au moins une portion du matériau électriquement conducteur non superposée aux autres électrodes du pixel et reliée électriquement à au moins un trou d'interconnexion traversant les couches de semi-conducteur amorphe et ladite portion non superposée aux autres électrodes, le trou d'interconnexion étant rempli par au moins un matériau électriquement conducteur,
- dans chaque pixel, des portions d'un matériau électriquement conducteur sont sensiblement superposées à chacune desdites portions d'électrodes non superposées aux autres électrodes du pixel et disposées au-dessus des couches de semi-conducteur amorphe.

Ainsi, on isole électriquement les connexions électriques des électrodes auxquelles elles ne sont pas reliées. De plus, on isole électriquement les électrodes dans les zones ombragées ou non éclairées, c'est-à-dire autour des électrodes (latéralement).

Chaque pixel du dispositif peut comprendre un empilement d'au moins deux photodiodes.

Dans chaque pixel, chaque électrode peut comporter au moins une portion du matériau électriquement conducteur non superposée aux autres électrodes du pixel et reliée électriquement à au moins un trou d'interconnexion, ou via, traversant les couches de semi-conducteur amorphe et ladite portion non superposée aux autres électrodes, le trou d'interconnexion pouvant être rempli par au moins un matériau électriquement conducteur. Ainsi, il est possible de réaliser des connexions électriques sous forme de vias, ces connexions étant reliées aux électrodes du dispositif de photo-détection et ne nécessitant pas d'éléments d'isolation électrique autres que les couches de semi-conducteur amorphe.

Le dispositif peut comporter en outre au moins un circuit intégré relié électriquement à au moins une couche d'interconnexions électriques disposée entre le circuit intégré et l'empilement de photodiodes, le matériau électriquement conducteur des trous d'interconnexion étant relié électriquement au moins à la couche d'interconnexions électriques.

Dans chaque pixel, l'une des électrodes peut être disposée entre la couche d'interconnexions électriques et l'empilement de photodiodes, et les autres électrodes du pixel peuvent être à base d'au moins un matériau transparent aux longueurs d'ondes destinées à être détectées par les photodiodes.

Le matériau électriquement conducteur des trous d'interconnexion peut être relié électriquement à la couche d'interconnexions électriques par l'intermédiaire d'au moins une portion de matériau électriquement conducteur disposée au niveau de ladite une des électrodes se trouvant entre la couche d'interconnexions électriques et l'empilement de photodiodes.

Dans chaque pixel, des portions d'un matériau électriquement conducteur peuvent être sensiblement superposées auxdites portions d'électrodes non superposées aux autres électrodes du pixel, les couches de semi-conducteur amorphe pouvant être disposées entre lesdites portions de matériau électriquement conducteur et la couche d'interconnexions électriques.

Dans chaque pixel, les électrodes peuvent être isolées électriquement des électrodes des pixels voisins par des portions des couches de semi-conducteur amorphe et/ou de portions d'au moins un matériau diélectrique disposées entre les empilements de photodiodes de deux pixels voisins.

Les couches de semi-conducteur amorphe intrinsèque et/ou les couches de semi-conducteur amorphe dopé peuvent être communes à plusieurs pixels du dispositif.

Au moins une des électrodes peut être commune à plusieurs pixels du dispositif.

Le dispositif peut comporter en outre au moins une couche de passivation recouvrant l'empilement de photodiodes.

Chaque pixel peut comporter au moins une micro-lentille disposée sur la couche de passivation.

Les couches de semi-conducteur amorphe peuvent être à base de Si:H (silicium hydrogéné), et/ou de Ge et/ou de SiGe et/ou de CdTe:O (tellure de cadmium oxygéné) et/ou de AsGa.

Des couches de semi-conducteur amorphe intrinsèque peuvent être en contact avec les électrodes par l'intermédiaire d'au moins une couche à base d'un matériau électriquement conducteur ou de semi-conducteur amorphe dopé.

Au moins une partie des électrodes et/ou des couches de semi-conducteur amorphe peuvent être réalisées par la mise en oeuvre d'une étape de dépôt du matériau des électrodes ou du semi-conducteur amorphe, puis d'étapes de photolithographie et de gravure du matériau déposé.

Le procédé peut comporter en outre, pour chaque pixel, la réalisation de trous d'interconnexion à travers des portions d'électrodes non superposées aux autres électrodes du pixel et les couches de semi-conducteur amorphe, puis le dépôt d'au moins un matériau électriquement conducteur dans les trous d'interconnexion.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente un capteur d'images CMOS du type « above IC » à filtres colorés selon l'art antérieur,
- la figure 2 représente un dispositif photo-détecteur de type « above IC » sans filtres colorés, objet de la présente invention, selon un premier mode de réalisation,
- les figures 3A et 3B représentent un dispositif photo-détecteur de type « above IC » sans filtres colorés, objet de la présente invention, selon un second mode de réalisation,
- la figure 4 représente un dispositif photo-détecteur de type « above IC » sans filtres colorés, objet de la présente invention, selon un troisième mode de réalisation,
- les figures 5A à 5C représentent des vues de dessus de quatre pixels de différents dispositifs photo-détecteurs de type « above IC » sans filtres colorés, objet de la présente invention, selon plusieurs variantes de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

On se réfère tout d'abord à la figure 2 qui représente un dispositif photo-détecteur 100, ou capteur d'images, de type « above IC », selon un premier mode de réalisation, ne comportant pas de filtres colorés.

De manière analogue au capteur 1 de l'art antérieur précédemment décrit, le dispositif photo-détecteur 100 se compose de deux parties : une partie de photo-détection formée par une rétine et une partie de traitement des charges électriques générées par la rétine formée notamment par un circuit intégré, la rétine étant disposée au-dessus du circuit intégré (above IC). Le circuit intégré comporte un substrat 102, par exemple à base de silicium, sur lequel sont réalisés des transistors CMOS 104. Une couche diélectrique 106, par exemple à base de SiO₂, recouvre les transistors CMOS 104. Plusieurs couches, ou niveaux, d'interconnexions électriques, reliées électriquement entre elles ainsi qu'aux transistors CMOS 104, sont réalisées dans la couche diélectrique 106. Sur l'exemple de la figure 2, le capteur 100 comporte une première couche d'interconnexions 108 et une seconde couche d'interconnexions 110.

La rétine, formée au-dessus de la couche diélectrique 106, comporte des électrodes inférieures 112 disposées sur la couche diélectrique 106. Dans ce premier mode de réalisation, chaque pixel du capteur 100 comporte une électrode inférieure 112. Ces électrodes inférieures 112 peuvent être à base d'un matériau électriquement conducteur pouvant absorber la lumière, tel que du graphite et/ou du graphen, ou réfléchir la lumière, tel que du métal (par exemple de l'aluminium et/ou du chrome et/ou du cuivre et/ou du tungstène et/ou du titane), ou encore un matériau transparent à la lumière tel que de l'ITO et/ou du SnO₂:F et/ou du Cd₂SnO₄ et/ou du Zn₂SnO₄ et/ou du ZnO. Le choix du matériau des électrodes inférieures 112 est réalisé notamment en fonction des conditions optiques imposées par la nature du semi-conducteur disposé sur ces électrodes. En fonction de la capacité d'absorption du semi-conducteur, le matériau de la première électrode sera choisi soit réfléchissant pour augmenter le signal du dispositif, soit absorbant si ce signal est suffisant.

Dans chaque pixel du dispositif 100 (deux pixels 101a et 101b sont représentés sur la figure 2), chacune des électrodes inférieures 112 est recouverte par un empilement de couches formant plusieurs photodiodes, par exemple trois sur l'exemple de la figure 2. Chaque photodiode comporte une couche de semi-conducteur amorphe intrinsèque 114a, 114b, 114c, disposée en contact avec une couche de semi-conducteur amorphe dopé 116a, 116b, 116c de type n ou p. Une électrode conductrice transparente 118a, 118b, 118c est également disposée en contact avec chacune des couches de semi-conducteur amorphe dopé 116a-116c.

Le semi-conducteur amorphe peut être à base de Si:H, de Ge, de SiGe, de CdTe:O ou encore d'AsGa. De plus, sur l'exemple de la figure 2, les couches de semi-conducteur amorphe 114 et 116 sont continues entre les pixels du capteur 100, c'est-à-dire communes pour tous les pixels du capteur 100.

Les électrodes 118a-118c ont par exemple une épaisseur (dimension selon l'axe y représenté sur la figure 2) comprise entre environ 30 nm et 300 nm lorsque ces électrodes sont à base d'un matériau conducteur transparent tel que de l'ITO.

Dans une variante, il est possible de réaliser les électrodes 118a-118c sous la forme d'une couche de métal, par exemple à base d'aluminium et d'épaisseur comprise entre environ 1 nm et 20 nm.

Dans une autre variante, il est également possible que chacune des électrodes 118a-118c soit formée par un empilement de plusieurs couches de matériaux électriquement conducteur transparents à la lumière reçue par le dispositif photo-détecteur 100. La taille des électrodes 118a-118c, qui est sensiblement similaires pour toutes les photodiodes et tous les pixels, délimite la taille des zones photosensibles du capteur 100.

Afin d'améliorer le contact électrique entre les électrodes 118a-118c et les couches de semi-conducteur amorphe dopé 116a-116c sur lesquelles sont disposées les électrodes 118a-118c, il est possible qu'une couche électriquement conductrice, non représentée sur la figure 2, soit disposée entre une électrode 118a-118c et une couche de semi-conducteur amorphe dopé 116a-116c. Dans ce cas, l'épaisseur de cette couche d'interface électriquement conductrice est choisie suffisamment fine, c'est-à-dire d'une épaisseur par exemple comprise entre environ 1 nm et 20 nm, pour qu'elle soit optiquement transparente.

Les couches de semi-conducteur amorphe intrinsèque 114a-114c et les couches dopées 116a-116c très fines, donc très faiblement conductrices, assurent l'isolation électrique entre les électrodes se trouvant sur un même niveau, c'est-à-dire se trouvant les unes à côté des autres, entre deux pixels voisins du dispositif. Ainsi, la première couche de semi-conducteur amorphe intrinsèque 114a assure l'isolation électrique entre les électrodes inférieures 112. Les deuxième et troisième couches de semi-conducteur amorphe intrinsèque 114b et 114c assurent respectivement l'isolation électrique entre les électrodes 118a et les électrodes 118b. Les électrodes 118c sont isolées électriquement les unes des autres par une couche diélectrique 120 recouvrant ces électrodes 118c et qui forme également une couche de planarisation sur laquelle des micro-lentilles 122 sont disposées (une par pixel), chacune de ces micro-lentilles 122 permettant de concentrer la lumière reçue au niveau de chaque pixel sur les photodiodes.

Dans chaque pixel, chacune des électrodes 118a-118c comporte une partie principale, par exemple de forme sensiblement rectangulaire, ainsi qu'une portion de matériau électriquement conducteur non superposée aux autres électrodes du pixel. Ces portions, décalées par rapport aux autres électrodes du pixel, permettent aux électrodes 118a-118c d'être connectées électriquement au circuit intégré du capteur 100 par l'intermédiaire de trous d'interconnexion, également appelés vias, par exemple à base de métal et traversant les empilements des couches de semi-conducteur amorphe 114a-114c, 116a-116c pour atteindre et être reliées électriquement aux couches d'interconnexions 108, 110, et cela tout en étant isolées électriquement des autres électrodes du pixel.

Pour le pixel 101a du dispositif 100 représenté sur la figure 2, la première électrode 118a comporte une telle portion 126a qui n'est pas superposée aux électrodes 118b, 118c du pixel 101a et qui est traversée par un trou d'interconnexion 124a métallique. Ainsi, le trou d'interconnexion 124a traverse l'empilement des couches de semi-conducteur amorphe 114a-114c, 116a-116c et relie électriquement la première électrode 118a, par l'intermédiaire de la portion 126a, à la seconde couche d'interconnexions 110 tout en étant isolée électriquement des autres électrodes 118b et 118c du pixel 101a. Bien que non représentées sur la figure 2, les autres électrodes 118b, 118c du pixel 101a comporte également chacune une portion de matériau électriquement conducteur non superposée aux autres électrodes du pixel 101a et reliée électriquement aux couches d'interconnexions 108 ou 110 par l'intermédiaire d'un trou d'interconnexion traversant les couches de semi-conducteur amorphe 114a-114c, 116a-116c tout en étant isolée électriquement des autres électrodes du pixel 101a.

Pour le pixel 101b du dispositif 100, la troisième électrode 118c comporte une portion 126c qui n'est pas superposée aux autres électrodes 118a, 118b du pixel 101b et qui est traversée par un trou d'interconnexion 124b. Le trou d'interconnexion 124b traverse les couches de semi-conducteur amorphe 114a-114c et 116a-116c et relie électriquement la troisième électrode 118c, par l'intermédiaire de sa portion 126c, au second niveau d'interconnexion 110. De manière analogue, les autres électrodes 118a, 118b du pixel 101b comporte également chacune une portion de matériau électriquement conducteur, non représentée sur la figure 2, non superposée aux autres électrodes du pixel 101b et reliée électriquement aux couches d'interconnexions 108 ou 110 par l'intermédiaire d'un trou d'interconnexion traversant les couches de semi-conducteur amorphe 114a-114c, 116a-116c sans être en contact électrique avec les autres électrodes du pixel 101b.

Chaque trou d'interconnexion 124a, 124c comporte une portion supérieure 128a, 128c masquant les portions 126a, 126c des électrodes 118a, 118c de la lumière reçue par le dispositif 100.

Lorsque le capteur 100 ne comporte pas de micro-lentilles 122, les trous d'interconnexion sont réalisés de préférence avec de telles portions supérieures permettant de masquer les portions du pixel qui ne sont pas destinées à réaliser une conversion photo-électrique de la lumière reçue, et cela afin d'éviter que le semi-conducteur amorphe ne devienne conducteur par les charges générées.

Ainsi, dans chaque pixel du dispositif 100, on forme plusieurs photodiodes (trois sur l'exemple de la figure 2) empilées les unes au-dessus des autres, chacune des photodiodes étant formée par la jonction entre une des couches de semi-conducteur amorphe intrinsèque 114a-114c et une des couches de semi-conducteur amorphe dopé 116a-116c. La lumière traversant ces couches de silicium amorphe 114a-114c, 116a-116c créée des charges électriques qui sont alors séparées par le champ électrique présent dans les photodiodes.

Les charges électriques collectées constituent le signal électrique qui est acheminé aux transistors 104, c'est-à-dire au circuit intégré du dispositif 100, par l'intermédiaire des trous d'interconnexion, puis amplifié par le circuit intégré du dispositif photo-détecteur 100. On obtient ainsi, pour chaque pixel, autant de signaux électriques que de photodiodes. Dans le dispositif 100 de la figure 2, étant donné que chaque photodiode est disposée entre deux électrodes, il est possible de collecter les charges électriques créées malgré la faible durée de vie de ces charges avant leur recombinaison et la faible conductivité du semi-conducteur amorphe.

De manière générale, chaque pixel du dispositif photo-détecteur 100 peut comporter n photodiodes ainsi que n+1 électrodes, avec n nombre entier ≥ 2. Bien que sur l'exemple de la figure 2 chaque pixel du dispositif 100 comporte des électrodes indépendantes les unes des autres, il est possible que des électrodes de chaque pixel se trouvant sur un même niveau soient formées par une électrode commune à plusieurs ou tous les pixels.

Les épaisseurs des différentes couches de semi-conducteur amorphe sont choisies en fonction de leurs indices optiques et des lois d'absorption optique des différents matériaux qui sont variables en fonction de la longueur d'onde de la lumière reçue. Le total de ces épaisseurs est par exemple inférieur à environ 0,7 µm, et l'épaisseur de chacune des couches est par exemple comprise entre environ 0,01 µm et 0,4 µm. Les longueurs et largeurs des pixels (correspondant aux dimensions dans le plan (X,Z) représenté sur la figure 2) sont par exemple supérieures à environ 0,7 µm, et généralement égales à environ 2 µm. Etant donné que les rapports largeur /hauteur et longueur / hauteur des pixels sont importants, cela confère au dispositif photo-détecteur une meilleure définition des couleurs et des pixels.

Cela permet également d'éviter qu'un photon arrivant en oblique sur la surface supérieure d'un pixel ne soit pas immédiatement absorbé et donc que sa trajectoire finisse sa course dans le pixel d'à côté, contrairement aux dispositifs photo-détecteurs de l'art antérieur dans lesquels les pixels sont plus haut que large (ou long). Le dispositif photo-détecteur 100 permet donc d'éviter des flous pouvant apparaitre sur les images ou des irisations aux limites des couleurs.

Les épaisseurs des couches de semi-conducteur amorphe des différentes photodiodes d'un même pixel sont différentes les unes des autres. Ces épaisseurs sont par exemple choisies telles qu'elles soient décroissantes dans le sens allant du circuit intégré du dispositif 100 vers la couche de passivation 120. Ainsi, la couche de semi-conducteur amorphe intrinsèque la plus proche du circuit intégré ou des niveaux d'interconnexions (couche 114a sur l'exemple de la figure 2) a donc l'épaisseur la plus importante. La couche de semi-conducteur amorphe intrinsèque la plus proche de la face d'entrée de la lumière du capteur 100 (couche 114c sur l'exemple de la figure 2), ou de la couche de passivation 120, a donc la plus petite épaisseur. Sur l'exemple de la figure 2, la première couche 114a a une épaisseur égale à environ 300 nm, la deuxième couche 114b a une épaisseur égale à environ 100 nm et la troisième couche 114c a une épaisseur égale à environ 15 nm.

A partir des signaux issus des trois photodiodes de chaque pixel, le circuit intégré réalise un calcul de trois équations linéaires à trois inconnues permettant d'obtenir avec le minimum d'erreur et de bruit les coordonnées colorimétriques de la lumière reçue par exemple selon la norme de la CIE 1931.

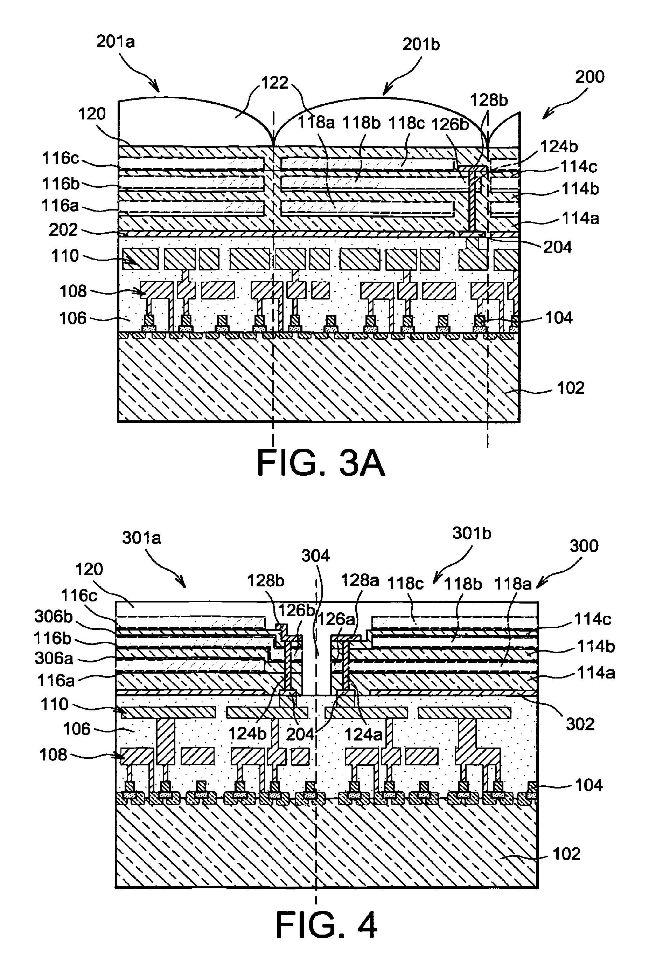

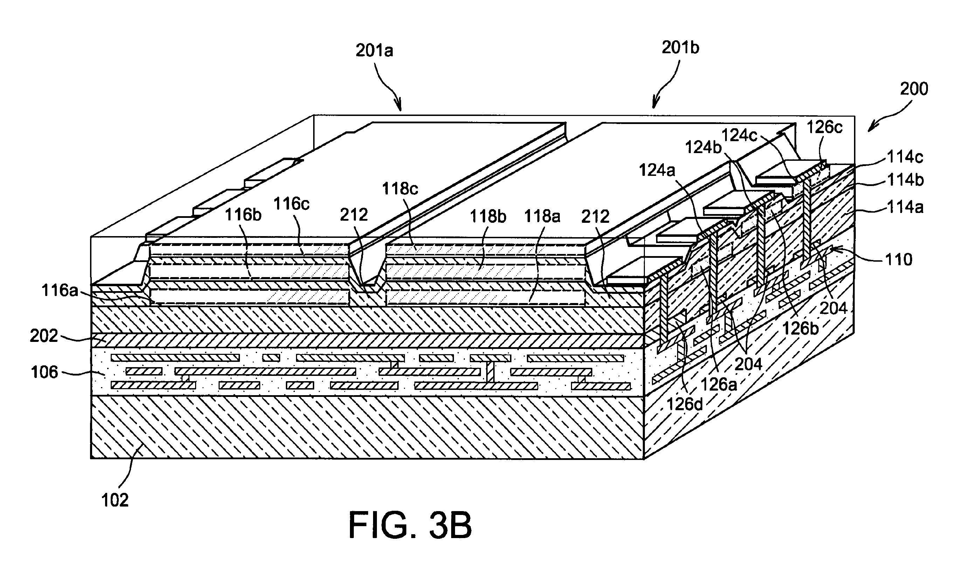

Les figures 3A et 3B représentent un dispositif photo-détecteur 200 selon un second mode de réalisation. Par rapport au dispositif 100 selon le premier mode de réalisation précédemment décrit, les couches 116a-116c de semi-conducteur amorphe dopé ne sont pas continues d'un pixel à l'autre du dispositif 200. Chacune de ces couches 116a-116c est formée par des portions distinctes et non reliées électriquement entre elles d'un pixel à l'autre. De plus, dans ce dispositif 200, les électrodes inférieures 112 sont remplacées par une seule électrode 202 commune à tous les pixels du dispositif photo-détecteur 200 et à base d'un matériau non transparent à la lumière. Cette électrode commune inférieure 202 est interrompue au niveau des trous d'interconnexion 124a-124c qui sont reliés électriquement à des plots de contact 204 disposés au même niveau que l'électrode commune inférieure 202 et assurant la connexion électrique entre les trous d'interconnexion 124a-124c et les couches d'interconnexions 108, 110 du dispositif photo-détecteur 200. Les trous d'interconnexion 124a-124c sont également surmontés de portions supérieures 128a-128c à base du même matériau que celui déposé dans les trous d'interconnexion.

Ce second mode de réalisation permet notamment de réaliser une électrode inférieure 202 à base d'un matériau conducteur autre que le matériau conducteur transparent utilisé pour réaliser les autres électrodes 118a-118c.

Dans ce second mode de réalisation, les trous d'interconnexion 124a-124c sont réalisés par gravure à travers les couches de semi-conducteur amorphe 114a-114c, 116a-116c ainsi qu'à travers les portions 126a-126c destinées à être reliées électriquement aux trous d'interconnexion 124a-124c.

Ces trous sont gravés, avantageusement, avec un seul masque avec arrêt au niveau des plots de contact 204. Enfin, étant donné que les couches 116a-116c de semi-conducteur amorphe dopé ne sont pas continues d'un pixel à l'autre du dispositif 200 mais formées par des portions distinctes et non reliées électriquement entre elles d'un pixel à l'autre, l'isolation électrique entre les électrodes et les trous d'interconnexion d'un pixel à l'autre est donc améliorée par rapport au dispositif 100 selon le premier mode de réalisation.

La figure 3B est une vue en perspective de deux pixels 201a, 201b du dispositif photo-détecteur 200. Sur cette figure, les micro-lentilles 122 ne sont pas représentées. Par contre, des passages de marche entre les pixels sont représentés sur la figure 3B et non sur la figure 3A. Dans ce second mode de réalisation, on voit que chacune des électrodes 118a-118c comporte une partie principale de forme sensiblement rectangulaire et est reliée électriquement à la seconde couche d'interconnexions 110 par l'intermédiaire de trous d'interconnexion 124a-124c reliés électriquement aux portions 126a-126c de ces électrodes. Il est toutefois possible que les électrodes présentent des surfaces et/ou des formes différentes, par exemple en raison des passages de marche entre les électrodes, tout en présentant de préférence une surface la plus importante possible. Des portions 212 des couches de semi-conducteur amorphe intrinsèque 114a-114c, au niveau des passages de marches formés notamment par les bords gravés des électrodes, assurent l'isolation électrique entre les électrodes 118a-118c des pixels adjacents et entre les trous d'interconnexion 124a-124c d'un même pixel.

Il est possible que l'électrode commune 202 soit reliée électriquement à la couche d'interconnexions 110 par des trous d'interconnexion réalisés au niveau de chaque pixel du dispositif 200.

Dans une variante, il est également possible que l'électrode commune 202 ne soit pas reliée électriquement à la couche d'interconnexions 110 au niveau de chaque pixel du dispositif 200, mais seulement au niveau d'une partie des pixels du dispositif 200, voire même, lorsque le matériau à partir duquel est réalisée l'électrode commune 202 est fortement conducteur, par exemple de l'aluminium, que dans un seul pixel du capteur 200, par un seul trou d'interconnexion.

La figure 4 représente un dispositif photo-détecteur 300 selon un troisième mode de réalisation.

Par rapport aux deux précédents modes de réalisation, les portions de silicium amorphe se trouvant entre les pixels du capteur 300 (deux pixels 301a, 301b sont représentés sur la figure 4) sont gravées puis remplies par un matériau diélectrique formant des portions d'isolation 304. Sur l'exemple de la figure 4, la portion d'isolation 304 isolant électriquement les pixels 301a, 301b est obtenue à partir du matériau formant la couche de planarisation 120 recouvrant les empilements de couches de semi-conducteur amorphe.

Dans ce troisième mode de réalisation, le dispositif photo-détecteur 300 comporte en outre des couches de contact 306a, 306b, par exemple à base d'un matériau électriquement conducteur, recouvrant les électrodes, ici les électrodes 118a, 118b des deux premières photodiodes. Ces couches de contact 306a, 306b permettent notamment de réaliser les électrodes conductrices transparentes 118a, 118b à partir d'un matériau présentant une conductivité électrique inférieure à celle de l'ITO. Ainsi, ces électrodes 118a, 118b peuvent être réalisées par exemple à partir d'In₂O₃ dopé Sn, de ZnO dopé Al, de SnO dopé F, d'InZnO, d'InMoO, d'InTiO ou encore de Ta₂O₅. L'épaisseur de ces couches de contact 306a, 306b est choisie suffisamment fine (épaisseur par exemple comprise entre environ 1 nm et 20 nm) pour que ces couches 306a, 306b soient transparentes à la lumière ou telles qu'elles présentent une absorption lumineuse négligeable, et qu'elles puissent être gravées en même temps que le matériau des électrodes 118a, 118b. Les couches de contact 306a, 306b sont par exemple à base d'un matériau électriquement conducteur transparent (tel que de l'ITO), ou à base d'un métal (par exemple de l'Al et/ou du Ti et/ou du W et/ou du Ta et/ou du Cr) ou d'un semi-conducteur amorphe dopé par exemple du type de dopage inverse au dopage des couches de semi-conducteur dopé 116a, 116b.

Dans ce mode de réalisation, les portions d'isolation 304 sont en contact avec la couche diélectrique 106, assurant l'isolation électrique entre les éléments des pixels. Dans une variante, et notamment lorsque les électrodes inférieures 302 sont formées par une seule électrode commune aux différents pixels du dispositif 300, il est possible que les portions d'isolation 304 ne traversent pas les électrodes inférieures 302 mais s'arrêtent au-dessus de ces électrodes inférieures 302.

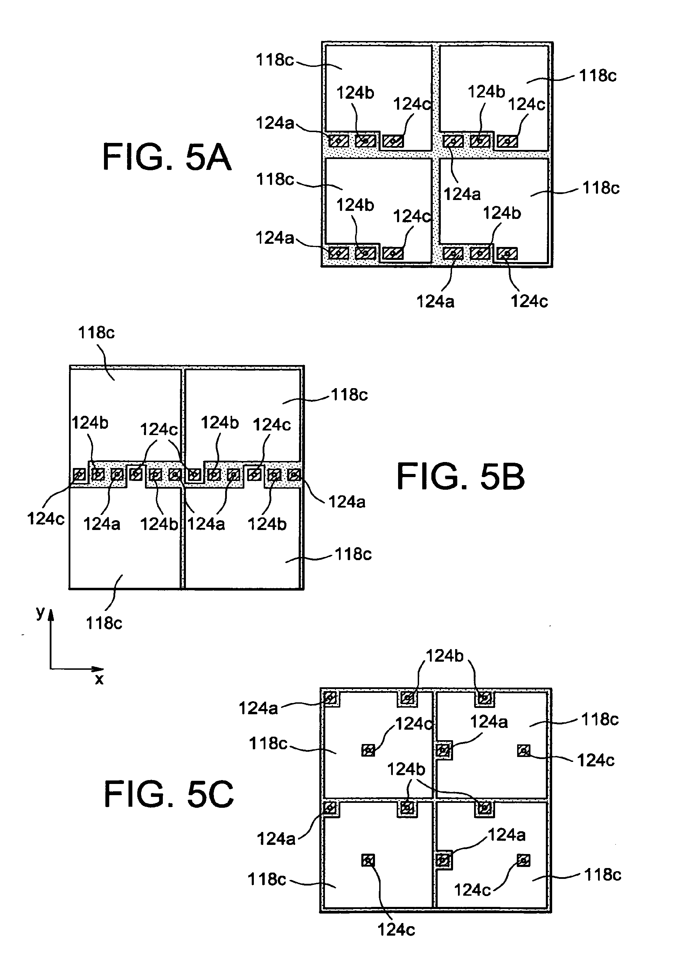

Les figures 5A, 5B et 5C représentent des vues de dessus de quatre pixels de différents dispositifs photo-détecteurs, par exemple similaires aux dispositifs 100, 200 et 300 précédemment décrits. Sur ces figures, seules les électrodes 118c se trouvant aux sommets des empilements de photodiodes sont représentées. Les électrodes 118c sont reliées électriquement aux trous d'interconnexion 124c. Les trous d'interconnexion 124a et 124b sont reliés électriquement aux électrodes 118a et 118b (non représentées). Sur l'exemple de la figure 5A, pour chaque pixel du dispositif photo-détecteur, les trous d'interconnexion 124a-124c sont disposés au niveau d'un côté de l'électrode 118c, cette disposition pouvant être similaire pour tous les pixels du dispositif photo-détecteur. Sur l'exemple de la figure 5B, les trous d'interconnexion 124a-124c de quatre pixels du dispositif photo-détecteur sont alignés les uns par rapport aux autres le long d'un axe parallèle à l'axe X représenté sur la figure 5B.

Cette disposition peut être répétée pour chaque groupe de quatre pixels du dispositif. Sur l'exemple de la figure 5C, les trous d'interconnexion 124a-124c de chaque pixel ne sont pas alignés les uns par rapport aux autres, mais disposés de façon à ce que les trous d'interconnexion 124a-124c soient éloignés le plus possible les uns des autres, et cela à la fois entre les trous d'interconnexion d'un même pixel et entre les trous d'interconnexion des pixels voisins.

Les dispositifs photo-détecteurs 100, 200 et 300 décrits précédemment peuvent être réalisés en mettant en oeuvre des étapes de dépôt, de photolithographie et de gravure successives sur le circuit intégré, et plus précisément sur la couche diélectrique 106, pour réaliser l'empilement de photodiodes. Après avoir réalisé l'empilement de photodiodes, les trous d'interconnexion sont formés à travers les couches de semi-conducteur amorphes et les portions d'électrodes non superposées aux autres électrodes du pixel. Un matériau électriquement conducteur est ensuite déposé dans les trous d'interconnexion. Le dispositif photo-détecteur peut ensuite être achevé par la mise en oeuvre d'étapes classiques de réalisation de capteurs d'images (dépôt de couche de planarisation, réalisation de micro-lentilles, ...).

## Revendications

1. Dispositif photo-détecteur (100, 200, 300) comportant une pluralité de pixels (101a-101b, 201a-201b, 301a-301b), chaque pixel comprenant au moins un empilement alterné de plusieurs photodiodes et de plusieurs électrodes (112, 118a-118c, 202, 302) à base d'un matériau électriquement conducteur, et dans lequel :
- chaque photodiode comporte au moins une couche de semi-conducteur amorphe intrinsèque (114a-114c) disposée en contact avec au moins une couche de semi-conducteur amorphe dopé (116a-116c) distinctes des couches de semi-conducteur amorphe des autres photodiodes, chaque photodiode étant disposée entre au moins deux desdites électrodes, et chaque paire de photodiodes comportant au moins une des électrodes (118b-118c) disposée entre ces photodiodes,
- dans chaque pixel, chaque électrode comporte au moins une portion (126a-126d) du matériau électriquement conducteur non superposée aux autres électrodes du pixel et au moins un trou d'interconnexion (124a-124d) traversant les couches de semi-conducteur amorphe et ladite portion non superposée aux autres électrodes, le trou d'interconnexion étant rempli par au moins un matériau électriquement conducteur relié électriquement à ladite portion (126a-126d) du matériau électriquement conducteur,
- chaque trou d'interconnexion (124a-126d) comporte une portion supérieure (128a-128d) à base du même matériau életriquement conducteur que celui déposé dans les trous d'interconnexion sensiblement superposée à chacune desdites portions d'électrodes non superposées aux autres électrodes du pixel et disposée au-dessus des couches de semi-conducteur amorphe.

2. Dispositif (100, 200, 300) selon la revendication 1, dans lequel chaque pixel (101a-101b, 201a-201b, 301a-301b) comprend un empilement d'au moins deux photodiodes.

3. Dispositif (100, 200, 300) selon l'une des revendications précédentes, comportant en outre au moins un circuit intégré (102, 104) relié électriquement à au moins une couche d'interconnexions électriques (108, 110) disposée entre le circuit intégré (102, 104) et l'empilement de photodiodes, le matériau électriquement conducteur des trous d'interconnexion (124a-124d) étant relié électriquement au moins à ladite couche d'interconnexions électriques (108, 110).

4. Dispositif (100, 200, 300) selon la revendication 3, dans lequel, dans chaque pixel (101a-101b, 201a-201b, 301a-301b), l'une des électrodes (112, 202, 302) est disposée entre la couche d'interconnexions électriques (108, 110) et l'empilement de photodiodes, et les autres électrodes (118a-118c) du pixel sont à base d'au moins un matériau transparent aux longueurs d'ondes destinées à être détectées par les photodiodes.

5. Dispositif (200, 300) selon la revendication 4, dans lequel le matériau électriquement conducteur des trous d'interconnexion (124a-124d) est relié électriquement à la couche d'interconnexions électriques (108, 110) par l'intermédiaire d'au moins une portion (204) de matériau électriquement conducteur disposée au niveau de ladite une des électrodes (202, 302) se trouvant entre la couche d'interconnexions électriques (108, 110) et l'empilement de photodiodes.

6. Dispositif (100, 200, 300) selon l'une des revendications précédentes, dans lequel, dans chaque pixel (101a-101b, 201a-201b, 301a-301b), les électrodes (112, 118a-118c, 202, 302) sont isolées électriquement des électrodes (112, 118a-118c, 202, 302) des pixels voisins (101a-101b, 201a-201b, 301a-301b) par des portions (212) des couches de semi-conducteur amorphe (114a-114c, 116a-116c) et/ou de portions (304) d'au moins un matériau diélectrique disposées entre les empilements de photodiodes de deux pixels voisins (101a-101b, 201a-201b, 301a-301b).

7. Dispositif (100, 200) selon l'une des revendications précédentes, dans lequel les couches de semi-conducteur amorphe intrinsèque (114a-114c) et/ou les couches de semi-conducteur amorphe dopé (116a-116c) sont communes à plusieurs pixels (101a-101b, 201a-201b) du dispositif (100, 200).

8. Dispositif (200) selon l'une des revendications précédentes, dans lequel au moins une des électrodes (202) est commune à plusieurs pixels (201a-201b) du dispositif (200).

9. Dispositif (100, 200, 300) selon l'une des revendications précédentes, comportant en outre au moins une couche de passivation (120) recouvrant l'empilement de photodiodes.

10. Dispositif (100, 200) selon la revendication 9, dans lequel chaque pixel (101a-101b, 201a-201b) comporte au moins une micro-lentille (122) disposée sur la couche de passivation (120).

11. Dispositif (100, 200, 300) selon l'une des revendications précédentes, dans lequel les couches de semi-conducteur amorphe (114a-114c, 116a-116c) sont à base de Si:H, et/ou de Ge et/ou de SiGe et/ou de CdTe:O et/ou de AsGa.

12. Dispositif (300) selon l'une des revendications précédentes, dans lequel des couches de semi-conducteur amorphe intrinsèque (114b-114c) sont en contact avec les électrodes (118a-118b) par l'intermédiaire d'au moins une couche (306a, 306b) à base d'un matériau électriquement conducteur ou de semi-conducteur amorphe dopé.

13. Procédé de réalisation d'un dispositif photo-détecteur (100, 200, 300) comportant une pluralité de pixels (101a-101b, 201a-201b, 301a-301b), le procédé comprenant, pour chaque pixel :
- la réalisation d'au moins un empilement alterné de plusieurs photodiodes et de plusieurs électrodes (112, 118a-118c, 202, 302) à base d'un matériau électriquement conducteur, tel que chaque photodiode comporte au moins une couche de semi-conducteur amorphe intrinsèque (114a-114c) disposée en contact avec au moins une couche de semi-conducteur amorphe dopé (116a-116c) distinctes des couches de semi-conducteur amorphe des autres photodiodes, chaque photodiode étant disposée entre au moins deux desdites électrodes, et chaque paire de photodiodes comportant au moins une des électrodes (118b-118c) disposée entre ces photodiodes,
- la réalisation de trous d'interconnexion (124a-124d) à travers des portions d'électrodes (126a-126d) non superposées aux autres électrodes du pixel et les couches de semi-conducteur amorphe, puis le dépôt d'au moins un matériau électriquement conducteur dans les trous d'interconnexion, le matériau électriquement conducteur étant relié électriquement auxdites portions d'électrodes (126a-126d),
- la réalisation de portions supérieures (128a-128d) à base du même matériau électriquement conducteur que celui déposé dans les trous d'interconnexion, telles que lesdites portions soient sensiblement superposées à chacune desdites portions d'électrodes non superposées aux autres électrodes du pixel et disposées au-dessus des couches de semi-conducteur amorphe et que lesdites portions (128a-128d) surmontent les trous d'interconnexion (124a-124d).

14. Procédé selon la revendication 13, dans lequel au moins une partie des électrodes (112, 118a-118c, 202, 302) et/ou des couches de semi-conducteur amorphe (114a-114c, 116a-116c) sont réalisées par la mise en oeuvre d'une étape de dépôt du matériau des électrodes (112, 118a-118c, 202, 302) ou du semi-conducteur amorphe, puis d'étapes de photolithographie et de gravure du matériau déposé.

## Patentansprüche

1. Fotodetektor-Einrichtung (100, 200, 300), umfassend eine Mehrzahl von Pixeln (101a-101b, 201a-201b, 301a-301b), wobei jedes Pixel wenigstens einen alternierenden Stapel aus mehreren Fotodioden und mehreren Elektroden (112, 118a-118c, 202, 302) auf Basis von einem elektrisch leitenden Material umfasst, und wobei:
- jede Fotodiode wenigstens eine intrinsische amorphe Halbleiter-Schicht (114a-114c) umfasst, die in Kontakt mit wenigstens einer dotierten amorphen Halbleiter-Schicht (116a-116c) angeordnet ist, die sich von den amorphen Halbleiter-Schichten der anderen Fotodioden unterscheiden, wobei jede Fotodiode zwischen wenigstens zwei von den Elektroden angeordnet ist, und jedes Paar von Fotodioden wenigstens eine der Elektroden (118b-118c) umfasst, die zwischen den Fotodioden angeordnet ist,
- in jedem Pixel, jede Elektrode wenigstens einen Abschnitt (126a-126d) aus dem elektrisch leitenden Material umfasst, der den anderen Elektroden des Pixels nicht überlagert ist, und wenigstens ein Verbindungsloch (124a-124d), welches die amorphen Halbleiter-Schichten und den Abschnitt durchquert, der den anderen Elektroden nicht überlagert ist, wobei das Verbindungsloch mit wenigstens einem elektrisch leitenden Material gefüllt ist, das elektrisch mit dem Abschnitt (126a-126d) des elektrischen leitenden Materials verbunden ist,
- jedes Verbindungsloch (124a-124d) einen oberen Abschnitt (128a-128d) auf Basis des gleichen elektrisch leitenden Materials umfasst wie demjenigen, das in den Verbindungslöchern aufgebracht wird, der im Wesentlichen jedem der Abschnitte der Elektroden überlagert ist, die nicht den anderen Elektroden des Pixels überlagert sind, und der oberhalb der amorphen Halbleiter-Schichten angeordnet ist.

2. Einrichtung (100, 200, 300) nach Anspruch 1, wobei jedes Pixel (101a-101b, 201a-201b, 301a-301b) einen Stapel von wenigstens zwei Fotodioden umfasst.

3. Einrichtung (100, 200, 300) nach einem der vorhergehenden Ansprüche, weiter umfassend wenigstens einen integrierten Schaltkreis (102, 104), der elektrisch mit wenigstens einer Schicht elektrischer Verbindungen (108, 110) verbunden ist, die zwischen dem integrierten Schaltkreis (102, 104) und dem Stapel von Fotodioden angeordnet ist, wobei das elektrisch leitende Material der Verbindungslöcher (124a-124d) elektrisch wenigstens mit der Schicht elektrischer Verbindungen (108, 110) verbunden ist.

4. Einrichtung (100, 200, 300) nach Anspruch 3, wobei, in jedem Pixel (101a-101b, 201a-201b, 301a-301b) die eine der Elektroden (112, 202, 302) zwischen der Schicht elektrischer Verbindungen (108, 110) und dem Fotodioden-Stapel angeordnet ist, und die anderen Elektroden (118a-118c) des Pixels auf wenigstens einem Material basieren, das transparent für die Wellenlängen ist, die dazu bestimmt sind, durch die Fotodioden detektiert zu werden.

5. Einrichtung (200, 300) nach Anspruch 4, wobei das elektrisch leitende Material der Verbindungslöcher (124a-124d) elektrisch mit der Schicht elektrischer Verbindungen (108, 110) vermittels wenigstens einem Abschnitt (204) aus einem elektrisch leitenden Material verbunden ist, der auf Höhe der einen der Elektroden (202, 302) angeordnet ist, die sich zwischen der Schicht elektrischer Verbindungen (108, 110) und dem Stapel von Fotodioden befindet.

6. Einrichtung (100, 200, 300) nach einem der vorhergehenden Ansprüche, wobei, in jedem Pixel (101a-101b, 201a-201b, 301a-301b) die Elektroden (112, 118a-118c, 202, 302) elektrisch von den Elektroden (112, 118a-118c, 202, 302) der benachbarten Pixel (101a-101b, 201a-201b, 301a-301b) isoliert sind, durch Abschnitte (212) von amorphen Halbleiter-Schichten (114a-114c, 116a-116c) oder/und durch Abschnitte (304) aus wenigstens einem dielektrischen Material, die zwischen den Stapeln von Fotodioden von zwei benachbarten Pixeln (101a-101b, 201a-201b, 301a-301b) angeordnet sind.

7. Einrichtung (100, 200) nach einem der vorhergehenden Ansprüche, wobei die intrinsischen amorphen Halbleiter-Schichten (114a-114c) oder/und die dotierten amorphen Halbleiter-Schichten (116a-116c) mehreren Pixeln (101a-101b, 201a-201b) der Einrichtung (100, 200) gemeinsam sind.

8. Einrichtung (200) nach einem der vorhergehenden Ansprüche, wobei wenigstens eine der Elektroden (202) mehreren Pixeln (201 a-201 b) der Einrichtung (200) gemeinsam ist.

9. Einrichtung (100, 200, 300) nach einem der vorhergehenden Ansprüche, weiterhin umfassend wenigstens eine Passivierungsschicht (120), welche den Stapel von Fotodioden bedeckt.

10. Einrichtung (100, 200) nach Anspruch 9, wobei jedes Pixel (101a-101b, 201a-201b) wenigstens eine Mikro-Linse (122) umfasst, die auf der Passivierungsschicht (120) angeordnet ist.

11. Einrichtung (100, 200, 300) nach einem der vorhergehenden Ansprüche, wobei die amorphen Halbleiter-Schichten (114a-114c, 116a-116c) auf Si:H oder/und Ge oder/und SiGe oder/und CdTe:O oder/und AsGa basieren.

12. Einrichtung (300) nach einem der vorhergehenden Ansprüche, wobei die intrinsischen amorphen Halbleiter-Schichten (114b-114c) vermittels wenigstens einer Schicht (306a, 306b) auf Basis von einem elektrisch leitenden Material oder einem dotierten amorphen Halbleiter in Kontakt mit den Elektroden (118a-118b) stehen.

13. Verfahren zur Herstellung einer Fotodetektor-Einrichtung (100, 200, 300), umfassend eine Mehrzahl von Pixeln (101a-101b, 201a-201b, 301a-301b), wobei das Verfahren für jedes Pixel umfasst:
- die Herstellung von wenigstens einem alternierenden Stapel von mehreren Fotodioden und mehreren Elektroden (112, 118a-118c, 202, 302) auf Basis von einem elektrisch leitenden Material, so dass jede Fotodiode wenigstens eine intrinsische amorphe Halbleiter-Schicht (114a-114c) umfasst, die in Kontakt mit wenigstens einer amorphen dotierten Halbleiter-Schicht (116a-116c) angeordnet ist, die sich von den amorphen Halbleiter-Schichten der anderen Fotodioden unterscheiden, wobei jede Fotodiode zwischen wenigstens zwei der Elektroden angeordnet ist, und jedes Paar von Fotodioden wenigstens eine der Elektroden (118b-118c) umfasst, die zwischen den Fotodioden angeordnet ist,
- die Herstellung von Verbindungslöchern (124a-124d) durch Abschnitte von Elektroden (126a-126d), die nicht anderen Elektroden des Pixels überlagert sind, und durch die amorphen Halbleiter-Schichten hindurch, dann das Aufbringen von wenigstens einem elektrisch leitenden Material in den Verbindungslöchern, wobei das elektrisch leitende Material elektrisch mit den Abschnitten der Elektroden (126a-126d) verbunden ist,
- die Herstellung von oberen Abschnitten (128a-128d) auf Basis des gleichen elektrisch leitenden Materials wie dem, das in den Verbindungslöchern aufgebracht wird, so dass die Abschnitte im Wesentlichen jedem der Abschnitte von Elektroden überlagert sind, die nicht anderen Elektroden des Pixels überlagert sind, und oberhalb der amorphen Halbleiter-Schichten angeordnet sind, und dass die Abschnitte (128a-128d) die Verbindungslöcher (124a-124d) überragen.

14. Verfahren nach Anspruch 13, wobei wenigstens ein Teil der Elektroden (112, 118a-118c, 202, 302) oder/und der amorphen Halbleiter-Schichten (114a-114c, 116a-116c) hergestellt werden, indem ein Schritt des Aufbringens des Materials der Elektroden (112, 118a-118c, 202, 302) oder des amorphen Halbleiters durchgeführt wird, und dann Schritte der Fotolithografie und des Ätzens des aufgebrachten Materials.

## Claims

1. Photo-detecting device (100, 200, 300) comprising a plurality of pixels (101a-101b, 201a-201b, 301a-301b), each pixel comprising at least one alternate stack of several photodiodes and several electrodes (112, 118a-118c, 202, 302) based on an electrically conducting material, and in which:
- each photodiode comprises at least one intrinsic amorphous semiconductor layer (114a-114c) arranged in contact with at least one doped amorphous semiconductor layer (116a-116c) distinct from the amorphous semiconductor layers in other photodiodes, each photodiode being arranged between at least two of said electrodes, and each pair of photodiodes comprising at least one of the electrodes (118b-118c) arranged between these photodiodes,
- in each pixel, each electrode comprises at least one portion (126a-126d) of electrically conducting material not superposed on the other pixel electrodes and at least one interconnection hole (124a-124d) passing through the amorphous semiconductor layers and said portion not superposed on the other electrodes, the interconnection hole being filled with at least one electrically conducting material electrically connected to said portion (126a-126d) of electrically conducting material,
- each interconnection hole (124a-124d) comprising an upper portion (128a-128d) based on the same electrically conducting material as that deposited in interconnection holes (124a-124d) superposed approximately on each of said portions of electrodes not superposed on other electrodes of the pixel and arranged above the amorphous semiconductor layers.

2. Device (100, 200, 300) according to claim 1, in which each pixel (101a-101b, 201a-201b, 301%-301b) comprises a stack of at least two photodiodes.

3. Device (100, 200, 300) according to one of the previous claims, also comprising at least one integrated circuit (102, 104) electrically connected to at least one layer of electrical interconnections (108, 110) arranged between the integrated circuit (102, 104) and the stack of photodiodes, the electrically conducting material of the interconnection holes (124a-124d) being electrically connected to at least said layer of electrical interconnections (108, 110).

4. Device (100, 200, 300) according to claim 3, in which, in each pixel (101a-101b, 201a-201b, 301a-301b), one of the electrodes (112, 202, 302) is placed between the layer of electrical interconnections (108, 110) and the stack of photodiodes, and the other electrodes (118a-118c) of the pixel are based on at least one material transparent at the wavelengths to be detected by the photodiodes.

5. Device (200, 300) according to claim 4, in which the electrically conducting material of the interconnection holes (124a-124d) is electrically connected to the layer of electrical interconnections (108, 110) through at least one portion (204) of electrically conducting material arranged at said one of the electrodes (202, 302) located between the layer of electrical interconnections (108, 110) and the stack of photodiodes.

6. Device (100, 200, 300) according to one of the previous claims, in which, in each pixel (101a-101b, 201a-201b, 301a-301b), the electrodes (112, 118a-118c, 202, 302) are electrically insulated from the electrodes (112, 118a-118c, 202, 302) of adjacent pixels (101a-101b, 201a-201b, 301a-301b) by portions (212) of amorphous semiconductor layers (114a-114c, 116a-116c) and/or portions (304) of at least one dielectric material arranged between the stacks of photodiodes of two adjacent pixels (101a-101b, 201a-201b, 301a-301b).

7. Device (100, 200) according to one of the previous claims, in which the intrinsic amorphous semiconductor layers (114a -114c) and/or the doped amorphous semiconductor layers (116a-116c) are common to several pixels (101a-101b, 201a-201b) of the device (100, 200).

8. Device (200) according to one of the previous claims, in which at least one of the electrodes (202) is common to several pixels (201a-201b) of the device (200).

9. Device (100, 200, 300) according to one of the previous claims, comprising at least one passivation layer (120) covering the stack of photodiodes.

10. Device (100, 200) according to claim 9, in which each pixel (101a-101b, 201a-201b) comprises at least one micro-lens (122) arranged on the passivation layer (120).

11. Device (100, 200, 300) according to one of the previous claims, in which the amorphous semiconductor layers (114a-114c, 116a-116c) are composed of Si:H, and/or Ge and/or SiGe and/or CdTe:O and/or AsGa.

12. Device (300) according to one of the previous claims, in which intrinsic amorphous semiconductor layers (114b-114c) are in contact with electrodes (118a-118b) through at least one layer (306a, 306b) composed of an electrically conducting material or a doped amorphous semiconductor.

13. Method of making a photo-detecting device (100, 200, 300) comprising a plurality of pixels (101a-101b, 201a-201b, 301a-301b), the method comprising, for each pixel:
- production of at least one alternating stack of several photodiodes and several electrodes (112, 118a-118c, 202, 302) based on an electrically conducting material, such that each photodiode comprises at least one layer of intrinsic amorphous semiconductor (114a-114c) arranged in contact with at least one layer of doped amorphous semiconductor (116a-116c) distinct from the amorphous semiconductor layers of other photodiodes, each photodiode being arranged between at least two of said electrodes, and each pair of photodiodes comprising at least one of the electrodes (118b-118c) arranged between these photodiodes,
- production of interconnection holes (124a-124d) through portions of electrodes (126a-126d) not superposed on other pixel electrodes and amorphous semiconductor layers, and then the deposition of at least one electrically conducting material in the interconnection holes, the electrically conducting material being electrically connected to said portions of electrodes (126a-126d)
- production of upper portions (128a-128d) based on the same electrically conducting material as that deposited in interconnection holes such that said portions are approximately superposed on each said portion of electrodes not superposed on the other electrodes of the pixel and arranged above the amorphous semiconductor layers and that said portions (128a-128d) rise interconnection holes (124a-124d).

14. Method according to claim 13, in which at least part of the electrodes (112, 118a-118c, 202, 302) and/or amorphous semiconductor layers (114a-114c, 116a-116c) are made by implementing a step of deposition of the material of the electrodes (112, 118a-118c, 202, 302) or the amorphous semiconductor, then photolithography and etching steps of the deposited material.
